# EUROPEAN PATENT APPLICATION

(11) **EP 3 404 729 A1**
(43) Date of publication of application: **21.11.2018**
(21) Application number: 17738381.7
(22) Date of filing: 10.01.2017
(51) Int. Cl.: H01L 35/26, B82Y 30/00, H01L 35/22, H01L 35/34, H01L 51/00, H01L 51/30, H01L 51/40

(54) **THERMOELECTRIC CONVERSION MATERIAL AND THERMOELECTRIC CONVERSION DEVICE**

(30) Priority: 13.01.2016 JP 2016004099
(71) Applicant: Sekisui Chemical Co., Ltd., Osaka-shi, Osaka 530-8565 (JP)
(72) Inventor: SASAKI, Taku, Mishima-gun Osaka 618-0021 (JP); ISHIMARU, Masatoshi, Mishima-gun Osaka 618-0021 (JP)
(74) Representative: Ter Meer Steinmeister & Partner
(86) International application number: PCT/JP2017/000452
(87) International publication number: WO 2017/122627

(57) **Abstract**

The present invention provides a thermoelectric conversion material that can improve the stress-relaxation properties as well as improve the heat-insulation properties. The thermoelectric conversion material 1 according to the present invention contains carbon nanotubes, and has a plurality of first voids having a longest diameter of 500 nm or less and a plurality of second voids having a longest diameter of 2.5 µm or more.

## Description

### TECHNICAL FIELD

The present invention relates to a thermoelectric conversion material containing carbon nanotubes. The present invention also relates to a thermoelectric conversion device including the thermoelectric conversion material described above.

### BACKGROUND ART

Energy issues have been actively addressed in recent years, and techniques for recovering thermal energy are increasingly anticipated. Heat can be recovered in various scenes such as body temperature, solar heat, engines, and industrial exhaust heat, and is most common energy source. To achieve a low-carbon society having a high energy efficiency, a need for techniques for recovering thermal energy is increasing.

As a technique for recovering thermal energy, thermoelectric conversion devices based on the Seebeck effect (or the Peltier effect) have already been employed in various scenes, such as temperature-difference power generation, thermal sensors, and cooling. A thermoelectric conversion device has a modular structure in which a lot of thermocouples, which are combinations of a p-type semiconductor and an n-type semiconductor, are serially connected, for example. Such a thermoelectric conversion device has many advantages, such as causing no noise and vibration because of having no moving part, having no scale effect, being able to generating power with a small temperature difference, and being able to be integrated into various apparatuses and environments.

One example of the thermoelectric conversion device as described above is disclosed in the following Patent Document 1. A thermoelectric conversion device described in Patent Document 1 includes a stress relaxing layer, a flexible base material, and a thermoelectric conversion element in the lamination order mentioned. The thermoelectric conversion element includes a first electrode, a thermoelectric conversion layer containing an organic material, and a second electrode in the lamination order mentioned. The stress relaxing layer adjusts warping of the flexible base material. In the thermoelectric conversion layer, as the organic material, for example, conductive polymers and a conductive nanomaterial (in particular, CNTs) may be used in combination.

### Related Art Document

### Patent Document

Patent Document 1: JP 2015-092557 A

### SUMMARY OF THE INVENTION

### PROBLEMS TO BE SOLVED BY THE INVENTION

When a thermoelectric conversion material has a small thickness, the thermal insulating properties of the thermoelectric conversion material tend to be reduced. Thus, in a thermoelectric conversion material having a small thickness, when a high-temperature portion (heat source) is placed on one electrode side in the thickness direction and a low-temperature portion is placed on the other electrode side, it is difficult to enlarge the difference in the temperature between the electrodes. Meanwhile, in order to improve the thermal insulating properties of a thermoelectric conversion material, a thermoelectric conversion material prepared by combining materials having thermal insulating properties may be used. Such a combined thermoelectric conversion material, however, is likely to have low stress relaxation properties. When a stress is applied on such a combined thermoelectric conversion material, cracks may occur in the combined interface.

As described above, it is difficult to achieve both high thermal insulating properties and high stress relaxation properties in conventional thermoelectric conversion materials.

It is an object of the present invention to provide a thermoelectric conversion material that can improve stress relaxation properties as well as improve thermal insulating properties. It is another object of the present invention to provide a thermoelectric conversion device including the thermoelectric conversion material described above.

### MEANS FOR SOLVING THE PROBLEMS

According to a broad aspect of the present invention, there is provided a thermoelectric conversion material containing carbon nanotubes and having a plurality of first voids having a longest diameter of 500 nm or less and a plurality of second voids having a longest diameter of 2.5 µm or more.

In a specific aspect of the thermoelectric conversion material according to the present invention, the plurality of first voids has an average longest diameter of 25 nm or more and 500 nm or less.

In a specific aspect of the thermoelectric conversion material according to the present invention, the plurality of second voids has an average longest diameter of 2.5 µm or more and 50 µm or less.

In a specific aspect of the thermoelectric conversion material according to the present invention, the plurality of second voids has an average aspect ratio of 2 or more and 50 or less.

The thermoelectric conversion material according to the present invention is preferably a sheet thermoelectric conversion material.

In a specific aspect of the thermoelectric conversion material according to the present invention, the direction obtained by averaging all the length directions of the plurality of second voids is a direction parallel to a plane direction orthogonal to the thickness direction of the sheet thermoelectric conversion material or is a direction inclined at an angle of 30° or less with respect to a plane direction orthogonal to the thickness direction of the sheet thermoelectric conversion material.

In a specific aspect of the thermoelectric conversion material according to the present invention, the average thickness is 1 µm or more and 10 cm or less.

In a specific aspect of the thermoelectric conversion material according to the present invention, the void ratio of the thermoelectric conversion material ascribed to the plurality of first voids is 5% or more and 40% or less.

In a specific aspect of the thermoelectric conversion material according to the present invention, the void ratio of the thermoelectric conversion material ascribed to the plurality of second voids is 5% or more and 25% or less.

According to a broad aspect of the present invention, there is provided a thermoelectric conversion device including the thermoelectric conversion material aforementioned, a first electrode located on the surface of the thermoelectric conversion material, and a second electrode located on the surface of the thermoelectric conversion material in a position distant from the first electrode.

In a specific aspect of the thermoelectric conversion device according to the present invention, the thermoelectric conversion material is a sheet thermoelectric conversion material, the first electrode is located on one side of the thickness direction of the thermoelectric conversion material, and the second electrode is located on the other side opposite to the one side of the thickness direction of the thermoelectric conversion material.

### EFFECT OF THE INVENTION

The thermoelectric conversion material according to the present invention, which contains carbon nanotubes and has a plurality of first voids having a longest diameter of 500 nm or less and a plurality of second voids having a longest diameter of 2.5 µm or more, can have improved stress relaxation properties and improved thermal insulating properties.

### BRIEF DESCRIPTION OF DRAWINGS

[Fig. 1] Figure 1 is a cross-sectional view of a thermoelectric conversion device according to a first embodiment of the present invention.
[Fig. 2] Figure 2 is an FE-SEM photograph of a cross-section along the thickness direction of the thermoelectric conversion material of Example 1 (magnification: 10000×).
[Fig. 3] Figure 3 is an FE-SEM photograph of a cross-section along the thickness direction of the thermoelectric conversion material of Comparative Example 1 (magnification: 10000×).

### MODE(S) FOR CARRYING OUT THE INVENTION

The present invention will be described below in detail.

The thermoelectric conversion material according to the present invention contains carbon nanotubes. The thermoelectric conversion material according to the present invention has a plurality of first voids having a longest diameter of 500 nm or less and a plurality of second voids having a longest diameter of 2.5 µm or more.

The thermoelectric conversion material described above may be formed only of carbon nanotubes, and the thermoelectric conversion material may contain an absorbent, a residual solvent, a dopant or the like in addition to the carbon nanotubes. The thermoelectric conversion material containing carbon nanotubes contains carbon nanotubes in an amount of preferably 90% by weight or more and preferably 100% by weight or less.

In the present invention, of the voids contained in the thermoelectric conversion material, voids having a longest diameter of 500 nm or less are referred to as first voids. In the present invention, of the voids contained in the thermoelectric conversion material, voids having a longest diameter of 2.5 µm or more are referred to as second voids. The longest diameter described above is a longest diameter per void. The thermoelectric conversion material according to the present invention may have third voids having a longest diameter of more than 500 nm and less than 2.5 µm.

The thermoelectric conversion material described above has excellent thermal insulating properties because of having the specific plurality of first voids described above. The plurality of first voids, having a relatively small longest diameter, significantly contributes to an improvement in the thermal insulating properties. An improvement in the thermal insulating properties of the thermoelectric conversion material can enhance the temperature difference between electrodes located on the surface of the thermoelectric conversion material, enabling the thermoelectromotive force to increase. Furthermore, the plurality of first voids serves to improve the stress relaxation properties to some extent to thereby make it difficult to break the thermoelectric conversion material.

Additionally, the thermoelectric conversion material, which has the specific plurality of second voids, can considerably relax a stress to thereby considerably inhibit breakage of the thermoelectric conversion material. For example, even when the thermoelectric conversion material is bent, in the case where the plurality of second voids has a shape in which the direction obtained by averaging all the length directions is a direction inclined at an angle of 30° or less with respect to a plane direction orthogonal to the thickness direction and the average aspect ratio is 2 or more and 50 or less, the stress during bending can be further effectively relaxed, and additionally, cracks and fractures become further unlikely to occur in the thermoelectric conversion material. The plurality of second voids having a relatively large longest diameter particularly significantly contributes to an improvement in the stress relaxation properties.

In the present invention, it is possible to achieve both high thermal insulating properties and high stress relaxation properties, which have been difficult to achieve conventionally.

From the viewpoint of effectively improving the thermal insulating properties, the plurality of first voids has an average longest diameter of preferably 25 nm or more, more preferably 50 nm or more. From the viewpoint of effectively improving the thermal insulating properties, the plurality of first voids has an average longest diameter of preferably 500 nm or less, more preferably 400 nm or less. The average longest diameter of the plurality of first voids is determined by averaging the longest diameters of a plurality of first voids.

From the viewpoint of effectively improving the stress relaxation properties, the plurality of second voids has an average longest diameter of preferably 2.5 µm or more, more preferably 3.0 µm or more. From the viewpoint of effectively the improving stress relaxation properties, the plurality of second voids has an average longest diameter of preferably 50 µm or less, more preferably 45 µm or less. The average longest diameter of the plurality of second voids can be determined by averaging the longest diameters of a plurality of second voids.

From the viewpoint of effectively improving the stress relaxation properties, the plurality of second voids has an average aspect ratio of preferably 2 or more, preferably 50 or less, more preferably 40 or less. The above aspect ratio is the longest diameter/the shortest diameter. The above average aspect ratio can be determined by averaging the aspect ratios of the plurality of second voids.

The above longest diameter is the longest distance between two points on the surface portion constituting a first void or second void in observation of a cross section along the thickness direction of the thermoelectric conversion material. The above shortest diameter is the shortest distance between two points on the surface portion constituting a second void in observation of a cross section along the thickness direction of the thermoelectric conversion material. For such cross section observation, the cross section can be formed using a cross section polisher and the like and observed using an FE-SEM or the like. In the case where voids are not connected in a cross section portion but are connected in a region other than the cross section portion, the voids are regarded as one void. It is possible to recognize whether the voids are connected or not in a region other than the cross section portion from observation of a plurality of cross section portions in different cross section positions, the shape of the inner circumferential surface of the voids and the like.

The average longest diameter of the plurality of first voids or the plurality of second voids can be determined by, for example, calculating the average longest diameter of the plurality of first voids or the plurality of second voids in a 50 µm × 50 µm area in the above cross section. In observation of a plurality of cross sections (for example, observation of 20 cross sections), the longest diameter is preferably observed.

From the viewpoint of effectively improving the thermal insulating properties, the void ratio of the thermoelectric conversion material ascribed to the plurality of first voids is preferably 4.5% or more, more preferably 5% or more, still more preferably 7.5% or more. From the viewpoint of maintaining the sheet structure as the thermoelectric conversion material, the void ratio of the thermoelectric conversion material ascribed to the plurality of first voids is preferably 45% or less, more preferably 40% or less, still more preferably 35% or less.

From the viewpoint of effectively improving the stress relaxation properties, the void ratio of the thermoelectric conversion material ascribed to the plurality of second voids is preferably 4.5% or more, more preferably 5% or more, still more preferably 7.5% or more. From the viewpoint of maintaining the sheet structure as the thermoelectric conversion material, the void ratio of the thermoelectric conversion material ascribed to the plurality of second voids is preferably 26.5% or less, more preferably 25% or less, still more preferably 23.5% or less.

The above void ratio is a ratio of the area occupied by a plurality of first voids or a ratio of the area occupied by the plurality of second voids based on the 100% cross-sectional area, in observation of a cross section along the thickness direction of the thermoelectric conversion material. It is preferred to determine the ratio of the area occupied by the plurality of first voids or the plurality of second voids in a 50 µm × 50 µm area in the above cross section. For cross section observation, an FE-SEM or the like can be used. In observation of a plurality of cross sections (for example, observation of 20 cross sections), the ratio occupied by voids is preferably observed.

From the viewpoint of effectively improving the thermal insulating properties in the thickness direction, it is preferred that the direction obtained by averaging all the length directions of the plurality of second voids be a direction parallel to a plane direction orthogonal to the thickness direction of the sheet thermoelectric conversion material or be a direction inclined at an angle of 30° or less with respect to a plane direction orthogonal to the thickness direction of the sheet thermoelectric conversion material. When the direction obtained by averaging all the length directions of the plurality of second voids is inclined toward a plane direction orthogonal to the thickness direction of the sheet thermoelectric conversion material, the inclining angle is preferably 25° or less, more preferably 20° or less. In all the examples described below, the inclining angle was 30° or less.

Examples of the method for controlling the length direction of the plurality of second voids as described above include a method including compressing carbon nanotubes in the thickness direction during production of the thermoelectric conversion material, a method including depositing carbon nanotubes while decompression suction is performed during production of the thermoelectric conversion material, and a method including orienting and depositing carbon nanotubes by shear or other external force toward a plane direction orthogonal to the thickness direction during production of the thermoelectric conversion material.

The thermoelectric conversion material described above is preferably a sheet. The sheet thermoelectric conversion material may be bent. The thermoelectric conversion material may be non-woven fabric.

From the viewpoint of effectively improving the thermal insulating properties, the average thickness of the above sheet thermoelectric conversion material is preferably 0.75 µm or more, more preferably 1 µm or more, still more preferably 1.5 µm or more.

The average thickness of the above sheet thermoelectric conversion material is preferably 15 cm or less, more preferably 10 cm or less, still more preferably 7.5 cm or less.

In the present invention, even if the average thickness of the thermoelectric conversion material is small or the average thickness of the thermoelectric conversion material is less than above upper limit, it is possible to sufficiently improve its thermal insulating properties by the plurality of first voids.

Additionally, the above thermoelectric conversion material has the plurality of first voids and the plurality of second voids, and thus, the thermoelectric conversion material is easily impregnated with treatment material when the thermoelectric conversion material is subjected to treatment such as wet treatment or the like. A specific example of the above treatment includes treatment by which the thermoelectric conversion material is rendered into an n-type using doping material. In respect of the thermoelectric conversion material according to the present invention, it is possible to obtain a thermoelectric conversion material rendered into an n-type (n-type thermoelectric conversion material) efficiently.

The thermoelectric conversion device according to the present invention includes the above thermoelectric conversion material, a first electrode located on the surface of the thermoelectric conversion material, and a second electrode located on the surface of thermoelectric conversion material in a position distant from the first electrode.

The thermoelectric conversion device according to the present invention, including the above configuration, can improve the thermoelectromotive force and is unlikely to break.

Specific embodiments of the present invention will be described below with reference to the drawings.

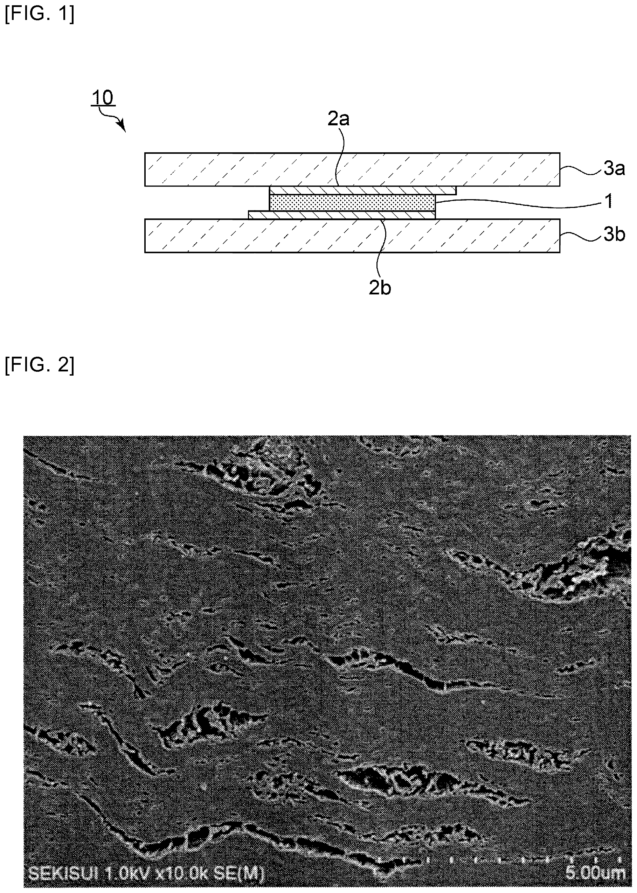

Figure 1 is a cross-sectional view of a thermoelectric conversion device according to a first embodiment of the present invention.

The drawings referred to in the embodiments are schematically illustrated, and the dimensional ratios of the objects and the like depicted in the drawings may differ from those of the actual objects. The specific dimensional ratios of the objects and the like should be determined with reference to the following description.

A thermoelectric conversion device 10 shown in Figure 1 includes a sheet thermoelectric conversion material 1, a first electrode 2a located on one side of the thickness direction of the thermoelectric conversion material 1, and a second electrode 2b located on the other side opposite to the one side of the thickness direction of the thermoelectric conversion material 1. The second electrode 2b is at a distance from the first electrode 2a.

The one first electrode 2a, the one thermoelectric conversion material 1, and the one second electrode 2b constitute one thermoelectric conversion element.

A first substrate 3a is provided on the side opposite to the thermoelectric conversion material 1 side of the first electrode 2a. A second substrate 3b is provided on the side opposite to the thermoelectric conversion material 1 side of the second electrode 2b. The material of the first substrate 3a and the second substrate 3b is a resin material such as polyimide, an appropriate ceramic material, or the like.

In the thermoelectric conversion device, a plurality of thermoelectric conversion materials may be laminated and used or may be continuously connected via the electrodes in the traverse direction in a cross-section along the thickness direction. The thermoelectric conversion device may further include a plurality of thermoelectric conversion elements. Alternatively, in the above thermoelectric conversion device, the above thermoelectric conversion material and an n-type thermoelectric conversion material obtained by treatment by which the thermoelectric conversion material is rendered into an n-type may be serially connected via electrodes.

In the thermoelectric conversion device 10 shown in Figure 1, the first electrode 2a is located on one side of the thickness direction of the thermoelectric conversion material 1, and the second electrode 2b is located on the other side opposite to the one side of the thickness direction of the thermoelectric conversion material 1. The arrangement of the first electrode 2a and the second electrode 2b is not limited to the above arrangement and may be changed as appropriate.

The present invention now will be described more in detail based on the specific embodiments.

### (Example 1)

### Production of Thermoelectric Conversion Material:

To 100 mL of N-methylpyrrolidone, 25 mg of single-walled carbon nanotubes (SWCNTs) having an average diameter of 2 nm and a G/D ratio of 50 was placed, and the mixture was stirred using a magnetic stirrer. Thereafter, the solution was subjected repeatedly to dispersion treatment three times (the number of repeats of the treatment) at a pressure of 100 MPa using a wet-type high-pressure collision homogenizer to obtain a SWCNT dispersion. The SWCNT dispersion obtained was filtered under reduced pressure using a membrane filter having a pore diameter of 0.2 µm to obtain an SWCNT deposit. The SWCNT deposit obtained was dried to obtain a thermoelectric conversion material having a thickness of 100 µm.

### Production of Thermoelectric Conversion Device:

Two polyimide substrates were provided. The substrates each had a rectangular plane shape with short sides of 5 cm and long sides of 10 cm and respectively had electrodes on one surface. Silver paste was applied onto the electrode portion on one of the polyimide substrates. On the silver paste, 100 pieces of the thermoelectric conversion material were mounted on the polyimide substrate such that the pieces were arranged side by side in the direction of the main plane of the substrate. The silver paste was further applied onto each thermoelectric conversion material pieces such that no short circuit occurred between the thermoelectric conversion material pieces. The substrates were laminated such that the electrode portion of the other polyimide substrate was superposed on the silver paste on the thermoelectric conversion material. There was obtained a laminate having continuous 100 pairs of configuration composed of the two polyimide substrates and the thermoelectric conversion material sandwiched therebetween. The periphery of the laminate obtained was sealed with a thermosetting resin and pressed under heating to thereby obtain a thermoelectric conversion device having a rectangular plane shape with short sides of 5 cm and long sides of 10 cm.

### (Example 2)

A thermoelectric conversion device was produced in the same manner as in Example 1 except that the number of repeats of the treatment by the wet-type high-pressure collision homogenizer was changed to five in production of the thermoelectric conversion material.

### (Example 3)

A thermoelectric conversion device was produced in the same manner as in Example 1 except that the number of repeats of the treatment by the wet-type high-pressure collision homogenizer was changed to one in production of the thermoelectric conversion material.

### (Example 4)

A thermoelectric conversion material obtained in the same manner as in Example 1 was immersed in a solution of 5% by weight of triphenylphosphine in methyl sulfoxide for 20 minutes. Then, the above thermoelectric conversion material was removed from the above solution and dried using a vacuum dryer at 80°C for 24 hours to obtain a thermoelectric conversion material rendered into an n-type (n-type thermoelectric conversion material). Subsequently, a thermoelectric conversion device was produced in the same manner as in Example 1 except that on the silver paste, 50 pieces of the thermoelectric conversion material and 50 pieces of the n-type thermoelectric conversion material were mounted on one of the polyimide substrates such that the pieces were alternatively arranged side by side in the direction of the main plane of the substrate in production of the thermoelectric conversion device.

### (Comparative Example 1)

A thermoelectric conversion device was produced in the same manner as in Example 1 except that the SWCNTs were replaced by SWCNTs having an average diameter of 2.5 nm and a G/D ratio of 15 and dispersion treatment on the SWCNTs was performed using a ultrasonic homogenizer under irradiation conditions of 300 W and 10 minutes in production of the thermoelectric conversion material.

### (Comparative Example 2)

A thermoelectric conversion device was produced in the same manner as in Example 1 except that dispersion treatment on the SWCNTs was performed using a ultrasonic homogenizer under irradiation conditions of 300 W and 10 minutes in production of the thermoelectric conversion material.

### (Comparative Example 3)

A thermoelectric conversion device was produced in the same manner as in Example 1 except that the SWCNTs were replaced by SWCNTs having an average diameter of 2.5 nm and a G/D ratio of 15 in production of the thermoelectric conversion material.

### (Comparative Example 4)

A thermoelectric conversion material obtained in the same manner as in Comparative Example 1 was immersed in a solution of 5% by weight of triphenylphosphine in methyl sulfoxide for 20 minutes. Then, the above thermoelectric conversion material was removed from the above solution and dried using a vacuum dryer at 80°C for 24 hours to obtain a thermoelectric conversion material rendered into an n-type (n-type thermoelectric conversion material). Subsequently, a thermoelectric conversion device was produced in the same manner as in Example 1 except that on the silver paste, 50 pieces of the thermoelectric conversion material and 50 pieces of the n-type thermoelectric conversion material were mounted on one of the polyimide substrates such that the pieces were alternatively arranged side by side in the direction of the main plane of the substrate in production of the thermoelectric conversion device.

### (Evaluation)

### Average Longest Diameter and Average Aspect Ratio of Voids, and Void Ratio:

The thermoelectric conversion material was cut with a cross section polisher along the thickness direction, and the cross section was observed with an FE-SEM. A total of 20 photographs of cross section observation were obtained by changing the position to be observed each time. Using the photographs of each cross section, the longest diameter and the aspect ratio of each void in a 50 µm × 50 µm area were measured to calculate the average longest diameter and the average aspect ratio of the voids. According to the size of the longest diameter, the first voids or the second voids was assigned. The void ratio ascribed to the first voids and the void ratio ascribed to the second voids in the 50 µm × 50 µm area were also calculated.

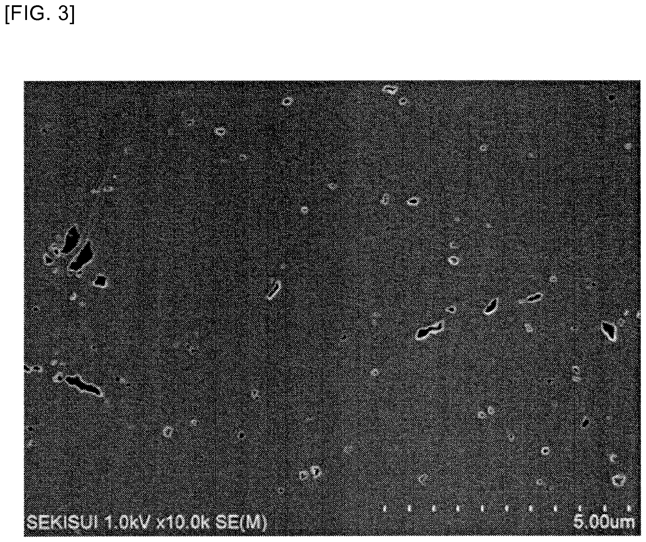

Figure 2 is an FE-SEM photograph in a cross-section along the thickness direction of the thermoelectric conversion material of Example 1 (magnification: 10000×). Figure 3 is an FE-SEM photograph in a cross-section along the thickness direction of the thermoelectric conversion material of Comparative Example 1 (magnification: 10000×).

As shown in Figure 3, Comparative Example 1 includes substantially no second void having a relatively large longest diameter. As shown in Figure 2, the first voids and the second voids are mixedly present and the void ratios ascribed both thereto are in a preferable range in Example 1.

### Thermal Insulating Properties:

The thermoelectric conversion material at room temperature (25°C) such that one side of the thickness direction was on the hot plate side was mounted on a hot plate at 100°C. When ten seconds passed after the material was mounted, the temperature of the surface of the thermoelectric conversion material opposite to the hot plate side was measured.

### Thermoelectric Performance:

The thermoelectric conversion device at room temperature (25°C) such that the polyimide substrate side was on the hot plate side was mounted on a hot plate at 100°C. The thermoelectric conversion device was heated to 100°C by the hot plate, and the upper surface of the thermoelectric conversion device was cooled by a Peltier device to a temperature of 25°C to impart a temperature difference of 75°C between the upper surface and the lower surface. Ten seconds after the temperature difference was imparted, the thermoelectromotive force of the thermoelectric conversion device was measured using a digital multimeter ("3680A" manufactured by Hewlett-Packard Company). The thermoelectromotive force of the thermoelectric conversion device obtained in Comparative Example 1 was taken as "1 (STD)" to relatively evaluate the thermoelectromotive force in Examples and other Comparative Examples.

### Stress Relaxation Properties/Deterioration Rate after Bending Test:

After the thermoelectromotive force of the thermoelectric conversion device was measured by the above method, bending test was performed by repeating an operation of winding the thermoelectric conversion device around a metal rod having a diameter of 5 cm 10 times. Thereafter, the thermoelectromotive force of the thermoelectric conversion device was measured again by the above method. The deterioration rate after the bending test to the thermoelectromotive force before the bending test was determined.

The results of the evaluation are shown in Table 1 below.

**[Table 1]**

| | First voids (relatively small voids) | | Second voids (relatively large voids) | | | Thermal insulating properties (°C) | Thermoelectric conversion device performance | |
|---|---|---|---|---|---|---|---|---|
| | Average longest diameter (nm) | Void ratio (%) | Average longest diameter (µm) | Void ratio (%) | Average aspect ratio | | Thermoelectromotive performance (thermoelectromotive force relative evaluation) | Stress relaxation properties Deterioration rate after bending test (%) |
| Example 1 | 125.7 | 11.1 | 8.4 | 17.7 | 12.6 | 67.3 | 4.3 | 12.1 |
| Example 2 | 78.1 | 8.7 | 3.2 | 9.4 | 5.9 | 71.4 | 3.6 | 18.4 |
| Example 3 | 398.5 | 32.6 | 41.2 | 23.5 | 36.7 | 61.1 | 2.4 | 9.4 |
| Example 4 | 125.7 | 11.1 | 8.4 | 17.7 | 12.6 | 69.0 | 7.9 | 11.0 |
| Comparative Example 1 | 94.2 | 2.9 | 1.4 | 4.1 | 1.9 | 91.0 | 1 (STD) | 67.5 |
| Comparative Example 2 | 574.3 | 14.2 | 61.2 | 27.4 | 1.2 | 84.7 | 0.6 | 84.3 |
| Comparative Example 3 | 145.4 | 46.1 | 2.2 | 1.9 | 1.7 | 77.4 | 0.7 | 53.4 |
| Comparative Example 4 | 94.2 | 2.9 | 1.4 | 4.1 | 1.9 | 90.8 | 1.8 | 64.8 |

As shown in Table 1, it can be seen that, in any of Comparative Examples 1 to 4, the thermal insulating properties are low and the temperature of the thermoelectric conversion material is higher than 75°C. In addition, it can be seen the deterioration rate after the bending test, which is high, is higher than 50% in any of the Comparative Examples. In Comparative Example 1, in which substantially no second void is included, the thermal insulating properties are particularly low.

It can be seen that the temperature of the thermoelectric conversion material is less than 72°C in any of Examples 1 to 4 and thus the thermal insulating properties are high. The thermoelectromotive performance exceeds twice that of Comparative Example 1 in any of the Examples. In addition, it can be seen that the deterioration rate after the bending test, which is less than 20% in any of the Examples, is low.

### EXPLANATION OF SYMBOLS

- 1: Thermoelectric conversion material
- 2a: First electrode
- 2b: Second electrode
- 3a: First substrate
- 3b: Second substrate
- 10: Thermoelectric conversion device

## Claims

1. A thermoelectric conversion material comprising carbon nanotubes, and
comprising a plurality of first voids having a longest diameter of 500 nm or less and a plurality of second voids having a longest diameter of 2.5 µm or more.

2. The thermoelectric conversion material according to claim 1, wherein the plurality of first voids has an average longest diameter of 25 nm or more and 500 nm or less.

3. The thermoelectric conversion material according to claim 1 or 2, wherein the plurality of second voids has an average longest diameter of 2.5 µm or more and 50 µm or less.

4. The thermoelectric conversion material according to any one of claims 1 to 3, wherein the plurality of second voids has an average aspect ratio of 2 or more and 50 or less.

5. The thermoelectric conversion material according to any one of claims 1 to 4, being a sheet thermoelectric conversion material.

6. The thermoelectric conversion material according to claim 5, wherein
a direction obtained by averaging all the length directions of the plurality of second voids is a direction parallel to a plane direction orthogonal to the thickness direction of the sheet thermoelectric conversion material or is a direction inclined at an angle of 30° or less with respect to a plane direction orthogonal to the thickness direction of the sheet thermoelectric conversion material.

7. The thermoelectric conversion material according to claim 5 or 6, wherein the average thickness is 1 µm or more and 10 cm or less.

8. The thermoelectric conversion material according to any one of claims 1 to 7, wherein the thermoelectric conversion material has a void ratio ascribed to the plurality of first voids of 5% or more and 40% or less.

9. The thermoelectric conversion material according to any one of claims 1 to 8, wherein the thermoelectric conversion material has a void ratio ascribed to the plurality of second voids of 5% or more and 25% or less.

10. A thermoelectric conversion device comprising:
the thermoelectric conversion material according to any one of claims 1 to 9;
a first electrode located on the surface of the thermoelectric conversion material; and
a second electrode located on the surface of the thermoelectric conversion material in a position distant from the first electrode.

11. A thermoelectric conversion device according to claim 10, wherein
the thermoelectric conversion material is a sheet thermoelectric conversion material,
the first electrode is located on one side of the thickness direction of the thermoelectric conversion material, and
the second electrode is located on the other side opposite to the one side of the thickness direction of the thermoelectric conversion material.
